# EUROPEAN PATENT SPECIFICATION

(11) **EP 0 951 138 B1**
(45) Date of publication and mention of the grant of the patent: **20.06.2007**
(21) Application number: 99660061.5
(22) Date of filing: 16.04.1999
(51) Int. Cl.: H03D 7/14

(54) **Method for attenuating spurious signals and receiver**
Verfahren zur Herabsetzung von Störsignalen und Empfänger
Procédé pour atténuer des signaux parasites et récepteur

(30) Priority: 17.04.1998 FI 980858
(43) Date of publication of application: 20.10.1999
(60) Divisional application: 06027107.9
(73) Proprietor: Nokia Corporation, 02150 Espoo (FI)
(72) Inventor: Murtojärvi, Simo, 24260 Salo (FI); Rauhala, Antti, 25130 Muurla (FI); Kimppa, Harri, 24280 Salo (FI)
(74) Representative: Niederkofler, Oswald

(56) References cited:
- WO-A-95/30275
- WO-A-97/07596
- US-A- 5 584 066
- PATENT ABSTRACTS OF JAPAN vol. 096, no. 006, 28 June 1996 (1996-06-28) & JP 08 056121 A (ADVANTEST CORP), 27 February 1996 (1996-02-27)
- PIAZZA F ET AL: "A 170 MHZ RF FRONT-END FOR ERMES PAGER APPLICATIONS" IEEE JOURNAL OF SOLID-STATE CIRCUITS, vol. 30, no. 12, 1 December 1995 (1995-12-01), pages 1430-1437, XP000557248 ISSN: 0018-9200

## Description

The invention relates to a method for attenuating spurious signals in a receiver in which radio signals are mixed to a second frequency, e.g. to an intermediate frequency (IF) or, in the case of so-called direct conversion, straight to the baseband, i.e. 0-Hz IF, and in addition the invention relates to a receiver. The invention thus pertains to a method defined in the preamble of claim 1 and a receiver defined in the preamble of claim 7.

When aiming at good linearity in radio reception, the biggest problem is usually the mixing of the received signal. Mixing is used for converting a high-frequency received signal down to a lower intermediate frequency. Attempts are made to attenuate in different ways the mixing results of even and odd orders which are brought about in the mixing in addition to the desired result. The mixing results of even orders are canceled by means of balanced or double-balanced mixer constructions. In the ideal situation, the even mixing results of two branches of a mixer cancel each other as being opposite. In practice, the attenuation caused by canceling is sufficient when the intermediate frequency is right and frequency-selective filtering is used. Then the frequencies causing the second order are attenuated already before the mixer down to a level where not too many of those frequencies will be generated in the mixer. However, there are receivers in which it is advantageous to use an intermediate frequency that might temporarily have a second-order spurious signal. Such a receiver is found e.g. in a multiple-frequency transceiver using one intermediate frequency and a common local oscillator.

Spurious responses will also be generated in a direct-conversion receiver, the worst being modulation-frequency interference at the receiver's mixer output caused by a strong amplitude-modulated (AM) signal of another transceiver. This will appear even if the frequency of the interfering signal considerably deviated from the receiving frequency. These interferences are mainly caused by the second-order distortion component which contains a variable-level DC component proportional to the amplitude of the interference-causing signal. The variable-amplitude signal produces at the mixer output a signal which comprises a variable DC component and the frequency of which is identical with the varying of the amplitude. This signal is attenuated in accordance with the mixer's balance accuracy and linearity. Sufficient attenuation can be achieved e.g. by using a mixer that has a good signal amplitude tolerance. In this way even spurious signals of a large amplitude will not cause a considerable interfering signal at the mixer output.

From the prior art it is known a so-called Gilbert cell which is widely used in integrated multiplier circuits of communications systems, especially in mobile communication devices. Multiplier circuits are used in integrated IF parts such as mixers and variable gain amplifiers.

A mixer can be based on a Gilbert cell. Such a mixer has to use large currents, high operating voltages and high local oscillator level to achieve a small relative portion of interfering signal and small effect on the mixer operating points. Additionally, the balance of the incoming RF signal, balance of the amplification of the different branches of the mixer, and the balance of the local oscillator are of great importance to the attenuation of spurious signals of even orders. The low voltage used nowadays because of the tendency to reduce power consumption causes that not all mixer types provide sufficient attenuation of spurious signals. Tolerances of the components used in the mixers are too wide to achieve a balance good enough at low voltages.

It is a problem with known radio receivers that single unbalanced mixers produce, in addition to the desired mixing result, spurious signals of both even and odd orders.

It is another problem with known radio receivers that spurious signals of even orders, which are generated in balanced mixers in addition to the desired mixing result, are insufficiently attenuated at low voltages.

A prior art document US-A-5 584 066 discloses balancing the mixer of a double superheterodyne receiver by adjusting bias voltages of transistors in the mixer in order to reduce carrier leakage through the mixer.

It is an object of the invention to improve the attenuation of spurious signals of even orders so that an adequate end result will be achieved even with low operating voltages and smaller currents.

The method according to the invention is characterized by what is expressed in claim 1. The receiver according to the invention is characterized by what is expressed in claim 7. Preferred embodiments of the invention are described in the dependent claims.

The invention pertains to a method for attenuating spurious signals in a mixer of a receiver in which radio signals are mixed to a second frequency which may also be the baseband frequency. Mixing is balanced by adjusting transistor base bias voltages and/or currents in those transistors of the mixer circuit that receive the local oscillator signal.

The invention also pertains to a receiver that comprises a mixer for mixing radio signals to a second frequency, which may also be the baseband frequency, and means for attenuating spurious signals while receiving radio signals. The means for attenuating spurious signals comprises balance-adjusting means of mixer circuit to adjust the balance of the circuit by adjusting transistor base bias voltages and/or currents in those transistors of the mixer circuit that receive the local oscillator signal.

It is an advantage of the invention that in the mixing to a second frequency spurious signals of even orders caused by balance errors resulting from component tolerances are considerably attenuated.

The invention will now be described in more detail with reference to the accompanying drawing wherein
- Fig. 1: shows in the form of circuit diagram a known Gilbert cell,
- Fig. 2: shows in the form of flow diagram a method according to the invention for adjusting the balance of a mixer,
- Fig. 3: shows in the form of circuit diagram a bias voltage adjustment block of a mixer according to the invention,
- Fig. 4: shows in the form of circuit diagram a mixer according to the invention,
- Fig. 5: shows in the form of circuit diagram a radio-frequency stage according to the invention,
- Fig. 6: shows in the form of block diagram essential parts of a transceiver according to the invention, and
- Fig. 7: shows in the form of block diagram a controller according to the invention for controlling an adjustment block.

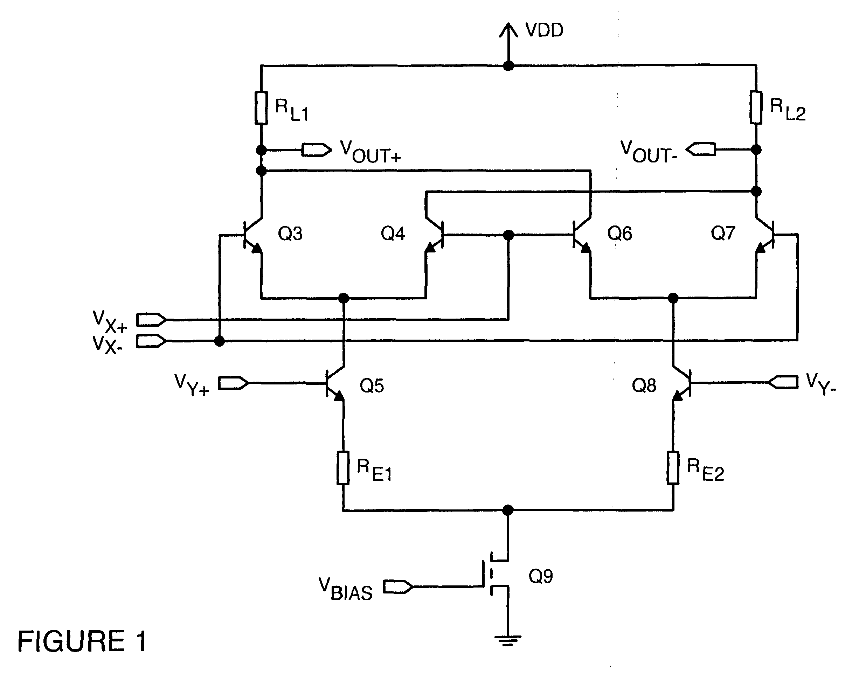

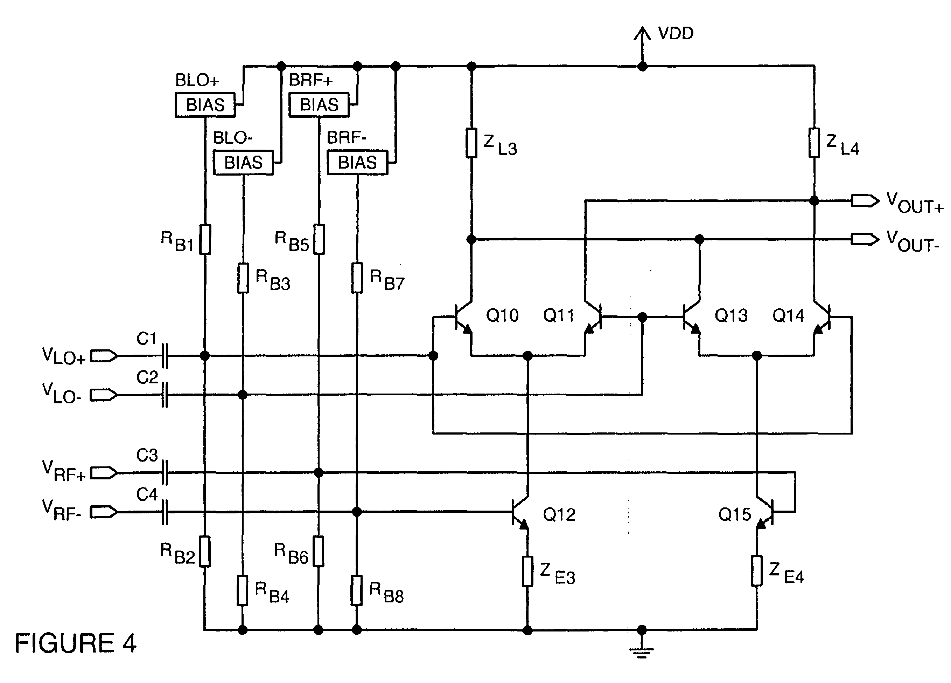

Fig. 1 shows a known Gilbert cell used for realizing integrated IF parts such as variable gain amplifiers and mixers. In a Gilbert cell two input voltages are multiplied into one output voltage, i.e. the voltage difference at the outputs is the product of the differences in the input voltages. A first voltage difference is coupled to terminals V_{X+} and V_{X-} wherefrom the voltages are taken to the bases of transistors Q3, Q4 and Q6, Q7, respectively. A second voltage difference is coupled to terminals V_{Y+} and V_{Y-} wherefrom the voltage is amplified by transistors Q5 and Q8. Transistors Q5 and Q8 are coupled through resistors R_{E1} and R_{E2} to a field effect transistor (FET) Q9 which is controlled by a bias voltage V_{BIAS} and coupled to a negative operating voltage. Transistors Q3 and Q7 amplify a positive voltage difference V_{X+} and V_{X-}, and the amplified voltage difference is coupled to outputs voltage through resistors R_{L1} and R_{L2}. Transistors Q2 and Q4 amplify a negative voltage difference V_{X+} and V_{X-}, and the amplified voltage difference is crosscoupled to outputs V_{OUT+} and V_{OUT-}.

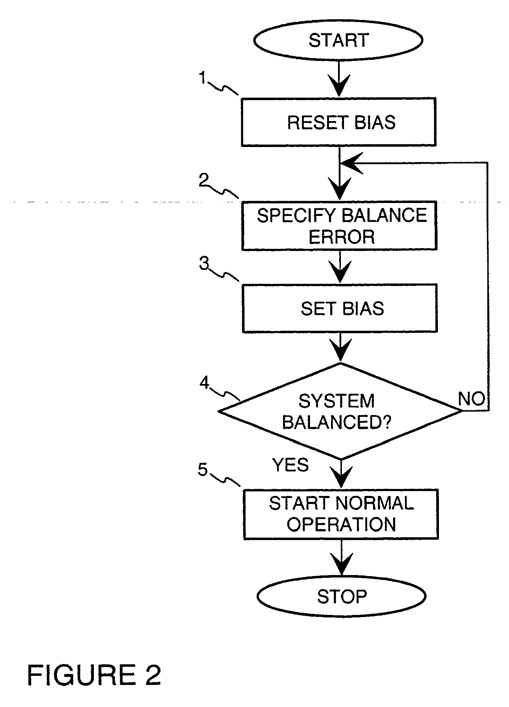

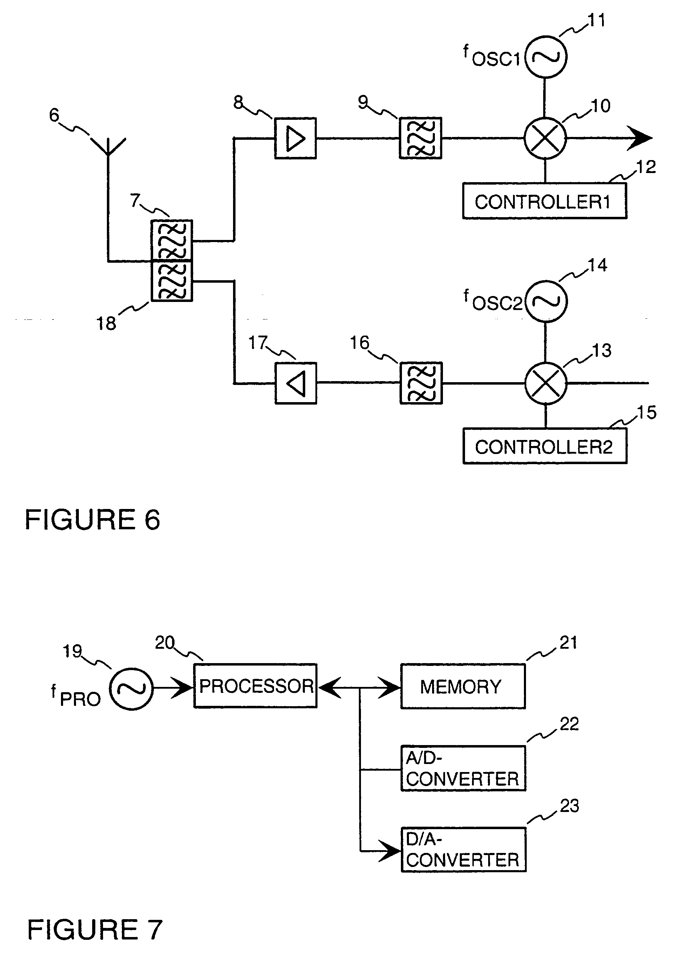

Fig. 2 shows in the form of flow diagram a balance adjustment method for a mixer according to the invention. First, possible previous bias voltages 1 are removed. Then, the balance error 2 of the mixer is determined by coupling a radio signal to the receiver inputs, thus causing a spurious signal in the mixer, which is then measured at the mixer outputs. Next, a bias voltage 3 correcting the balance error is set, preferably by feeding an inversely proportional CTRL byte corresponding to the error to the adjustment block by means of a digital controller. If the error-correcting bias voltage cannot be determined on the basis of the measurement result, a trial bias voltage is set. CTRL byte means a binary number that sets the control for the CTRL lines. The binary lines of the CTRL byte control the switching transistors in the adjustment block, so that I_{BIAS} is changed and the voltages between the terminals of the bias resistors change. The potential of the operating point of the mixer's transistor input is adjusted according to the point between the bias resistors. In other words, the adjustment block forms a variable voltage across the resistor in the series connection when the adjustment is carried out by means of current. The adjustment block may also be implemented using a variable voltage source. The operational input signals of the transistors are alternating voltages conducted by a capacitive component. When the bias voltage that corrects or at least changes the balance error has been generated, it is checked whether the error correction was successful, i.e. whether the mixer is in balance 4. If not, operation returns to step 2 to determine the remaining error and change the bias voltages on the basis of that determination. If the setting of the bias reduced the balance error, the bias is increased, but if the balance error became bigger the bias is taken back towards zero or, if zero is reached, the bias is set on the second line of the input pair. Thus, bias voltage remains advantageously only on one of the lines of the input pair in the balanced state. When the balancing has succeeded, the data of the balancing controller are stored in memory and normal operation of the mixer is started 5.

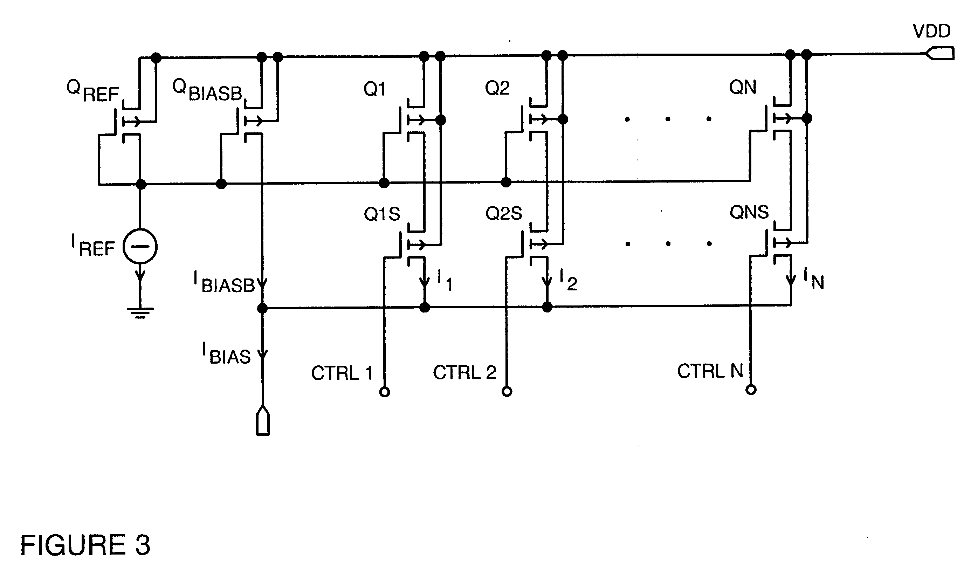

Fig. 3 shows in a circuit diagram an adjustment block for the bias voltage of a mixer according to the invention. In the adjustment block, a current from a reference current source I_{REF} flows via a transistor Q_{REF} from the operating voltage VDD to ground. Current I_{REF} is mirrored to a bias current circuit on the right. Current I_{BIASB} through transistor Q_{BIASB} constitutes the invariable fundamental part of bias current I_{BIAS}. Transistors Q1, Q2, ... QN and Q1S, Q2S, ... QNS make up N parallel series connections, and a sum current of I₁, I₂, ... IN through said series connections constitutes the variable part of bias current I_{BIAS}. Control lines CTRL 1, 2, ... N control transistors Q1S, Q2S, ... QNS serving as switches. Transistors Q1, Q2, ... QN are mutually binarily weighted such that transistors Q1S, Q2S, ... QNS, which are controlled by control lines CTRL 1, 2, ... N and connected in series with said transistors, can raise current I_{BIAS} by 2^{N}-1 levels, which means the current gets 2^{N} values. Binary weighting of the currents is achieved e.g. by connecting transistors in parallel in such a way that Q1 comprises one transistor, Q2 comprises two transistors, etc. With field effect transistors (FET), the currents may also be set by selecting the channel widths. The currents are weighted preferably according to the following series: 1, 2, 4, 8, etc., i.e. 2^{N}, where N ≥ 0. For example, current I₁ is I_{REF}/200, current I₂ is I_{REF}/100 and IN is I_{REF}/(200/2^{N-1}).

Thus the imbalance caused by the tolerances of mixer components can be balanced using the variable part I₁, I₂, ... IN of current I_{BIAS}. Also, possible small imbalance of input signals can be balanced using the arrangement according to the invention. By changing the number of control lines and the current I_{REF} of the reference current source it is possible to adapt the bias adjustment steps and range to various couplings.

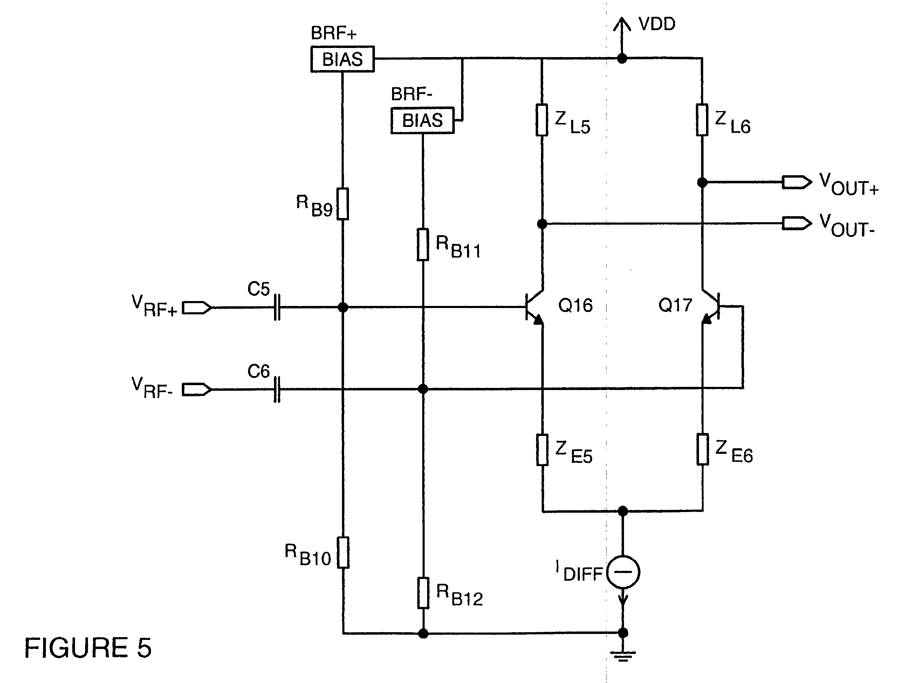

Fig. 4 shows in a circuit diagram a mixer according to the invention. In the upper left corner of Fig. 4 there are four blocks depicted in Fig. 3 that generate the bias current I_{BIAS} to control the bias voltage. The blocks are for local oscillator signal pair V_{LO+} and V_{LO-} and radio-frequency signal pair V_{RF+} and V_{RF-}, which control through capacitive elements C1 and C2 as well as C3 and C4 the transistors Q10, Q11, Q13, Q14 and Q12, Q15. Blocks BLO+, BLO-, BRF+ and BRF- are used to produce currents and, thus, voltages to four parallel bias resistor series connections R_{B1} and R_{B2}, R_{B3} and R_{B4}, R_{B5} and R_{B6} as well as R_{B7} and R_{B8}.

If the adjustment block current I_{BIAS} is the same as the necessary base current of the corresponding transistor, e.g. a beta-compensated base current, a resistor connected to ground is not used with that adjustment block. For example, if adjustment blocks BRF+ and BRF- feed the base current of transistors Q15 and Q12, resistors R_{B6} and R_{B8} are left out and the corresponding bias voltage is set by adjusting the base current.

Load impedances Z_{L3}, Z_{L4}, transistors Q10, Q11, Q12,Q13, Q14, Q15 and emitter impedances Z_{E3}, Z_{E4} constitute a known mixer the outputs of which give signals V_{OUT+} and V_{OUT-}.

The balance is adjusted preferably as described above, but the most perfect balance is achieved by adjusting the bias voltages of the transistor pair's mutually corresponding transistors Q10, Q11 and Q13, Q14 separately. In other words, the controls of the transistors that get their control from the same line, such as Q10 and Q14, are separated from each other and the bias voltages of them both are adjusted individually.

Fig. 5 shows in a circuit diagram a radio-frequency amplifier stage according to the invention which also can be used to correct a mixer's balance error. In the upper left corner of Fig. 5 there are two blocks depicted in Fig. 3 that generate the bias current I_{BIAS} to control the bias voltage. The blocks are for a radio-frequency signal pair V_{RF+} and V_{RF-} which control through capacitive elements C5 and C6 transistors Q16 and Q17. Blocks BRF+ and BRF- are used to produce currents and, thus, voltages to two parallel bias resistor series connections R_{B9}, R_{B10} and R_{B11}, R_{B12}.

Load impedances Z_{L5}, Z_{L6}, transistors Q16, Q17, emitter impedances Z_{E5}, Z_{E6} and current source I_{DIFF} constitute a known radio-frequency amplifier stage.

The circuit according to Fig. 5 described above can also be used as local oscillator buffer. Then the balance error of the local oscillator port can be corrected by adjusting the buffer.

Fig. 6 shows in the form of block diagram essential parts of a transceiver according to the invention. The transceiver shares a common antenna 6 from which a signal is received and filtered by a bandpass filter 7 and amplified by an amplifier 8 and refiltered 9. Then the signal at the radio reception frequency is mixed to an intermediate frequency in a balanced mixer 10 according to the invention. A local oscillator 11 feeds the mixer 10 at the frequency of f_{OSC1}. The balance of the mixer 10 is adjusted by a controller 12. From the intermediate frequency on the reception continues in accordance with the prior art.

A signal to be transmitted is modulated at the local oscillator 14 frequency f_{OSC2} by means of a modulator 13. The balance of the modulator 13 is adjusted by a controller 15. The modulated signal is bandpass-filtered by a filter 16 and amplified by an amplifier 17 and filtered again by a filter 18 and fed to the antenna 6. Otherwise the transmitter is preferably realized according to the prior art, and this document does not take a position on the use of balancing according to the invention in it.

Fig. 7 shows in a block diagram essential components of a controller of an adjustment block according to the invention. The processor 20 of a digital controller is stepped by an oscillator 19 at frequency F_{PRO}. The controller executes a program from memory 21, which preferably is both read only memory (ROM) and random access memory (RAM). Measurement data on the balance is obtained by means of an A/D converter 22. Bias voltages are controlled by a D/A converter 23 which preferably comprises an adjustment block according to Fig. 3 in which current is switched by means of digital binary control to adjust the bias voltages.

For example, let us consider a radio receiver the spurious response of which is to be reduced. The receiver is adjusted preferably only once before use. A test signal is coupled to the receiver input, and the interfering signal level is measured from the receiver output. The test signal is generated in such a way that it produces a spurious response to be minimized. A trial setting is chosen e.g. for the adjustment block BRF+ of the positive line of the RF input, and the interfering signal level is measured again. If the interference was reduced, an optimum setting is found for the adjustment block BRF+ by experimental bracketing, and if the interference got worse, the initial state is restored for the adjustment block BRF+ and a trial setting is chosen for the adjustment block BRF- of the negative line of the RF input and an optimum setting is found for it by experimental bracketing. The same experimental bracketing is also carried out for the local oscillator input by adjustment blocks BLO+ and BLO-. For a good result, both bracketing tunings are repeated. Thanks to the second tuning, a possible residual error, which is not noticed at the first time because it is hidden by an error in one of the input pairs, is corrected. Tuning data for the balance achieved through the minimization of spurious response are stored in the memory of the apparatus wherefrom they can be loaded by means of a microprocessor or digital signal processor (DSP) always on start-up. Fuses, microswitches, programmable gate circuits and the like can also be used for the immediate control of the adjustment block.

Of course, the selection of the bias voltage initial setting line and the level of the setting can also be realized as a preferably calculatory value based on interference measurement data. Empirical knowledge can also be utilized when estimating the bias voltage value on the basis of the measurement result.

In digital mobile communications devices, such as mobile stations operating in GSM, PCN (Personal Communication Network), DAMPS (Digital Advanced Mobile Phone Standard) or CDMA (Code Division Multiple Access) networks, the received signal is converted digital. In these apparatus the method is advantageously applied in such a way that the spurious response is measured, adjusted as small as possible, and the settings are stored in memory by carrying out the necessary routines with a digital signal processor. Then the tuning is particularly fast as it is carried out by coupling a test signal to the antenna and executing a tuning program. The adjustment blocks are controlled by a microprocessor or preferably with the same digital signal processor. A serial or parallel bus is used for the control. For a serial bus an adjustment block needs a separate logic to control the transistors.

The balance can also be tuned without a test signal while the local oscillator is operating. To that end, a comparative element is coupled to the mixer outputs to compare the voltage difference of the output pair. Particularly the DC component is compared. Tuning is performed by decreasing the voltage difference to its minimum value. However, because of bias voltages in the comparative element itself, the inputs of the comparative element must switch places and the comparison has to be repeated. The average of the tunings gives a result which is as accurate as possible. However, this tuning result is not as accurate as the one achieved using a test signal. If this type of tuning is accurate enough for the application, the tuning can be carried out automatically with a digital signal processor.

The exemplary adjustment block was here realized by field effect transistors but the circuit can also be realized using bipolar transistors, for example.

The invention is not limited to the exemplary embodiments described above but many modifications are possible within the scope of the inventional idea defined by the claims set forth below.

## Claims

1. A method for attenuating spurious signals in a mixer of a receiver in which radio signals of a first frequency are mixed to a second frequency, wherein the mixing is accomplished in a Gilbert cell having four upper transistors (Q10, Q11, Q13, Q14) that receive a local oscillator signal at their bases, and two lower transistors (Q12, Q15) that receive said signals of a first frequency at their bases and are coupled to said four upper transistors (Q 10, Q11, Q13, Q 14), **characterized in that** the mixer is balanced by adjusting bias voltages (3) and/or currents applied to the bases of selected ones of said upper transistors.

2. The method of claim 1, **characterized in that** bias voltages and/or currents are also adjusted (3) in an input circuit that connects a local oscillator input (V_{LO+}, V_{LO-}) to the base of an upper transistor (Q10, Q11, Q13, Q14).

3. The method of claim 1 or 2, **characterized in that** bias voltages and/or currents are also adjusted (3) in an input circuit that receives said signals of a first frequency and couples them to the base of a lower transistor (Q12, Q15).

4. The method of claim 1, 2 or 3, **characterized in that** the bias voltages (3) and/or currents are adjusted separately for both transistors of a transistor pair of a signal line in the mixer circuit.

5. The method of any one of the preceding claims 1 to 4, **characterized in that** the adjustment of the bias voltages (3) and/or currents is performed using a digital-to-analog converter that generates a bias current corresponding to a control byte fed thereto.

6. The method of any one of the preceding claims 1 to 5, **characterized in that** the bias voltages (3) and/or currents are adjusted by measuring (2) a balance from the outputs of a receiver that includes said mixer and empirically adjusting the bias voltages (3) and/or currents on the basis of such measurements (4).

7. A receiver comprising a mixer (10) for mixing radio signals of a first frequency to a second frequency, comprising:
- a Gilbert cell having four upper transistors (Q10, Q11, Q 13, Q 14) with their bases coupled to local oscillator inputs of the mixer, and two lower transistors (Q12, Q 15) coupled to receive said signals of a first frequency at their bases and coupled to said four upper transistors (Q10, Q11, Q13, Q14), and
- means for attenuating spurious signals,
**characterized in that** the means for attenuating spurious signals comprises balance adjustment means (12) configured to adjust the mixer's balance by adjusting bias voltages and/or currents applied to the bases of selected ones of said upper transistors (Q10, Q11, Q 13, Q 14).

8. The receiver of claim 7, **characterized in that** the adjustment means (12) comprises a block (BLO+, BLO-) adapted to control the bias voltage of a coupling between a local oscillator input (V_{LO+}, V_{LO-}) and the bases of the upper transistors coupled to that local oscillator input.

9. The receiver of claim 7 or 8, **characterized in that** the adjustment means (12) comprises a block (BRF+, BRF-) adapted to control the bias voltage of a coupling between an input (V_{RF+}, V_{RF-}) configured to receive said signals of a first frequency and the base of the lower transistor coupled to that input.

10. The receiver of claim 7, 8 or 9, **characterized in that** the adjustment means (12) comprises both a block (BLO+, BLO-) adapted to control the bias voltage of a coupling between a local oscillator input (V_{LO+}, V_{LO-}) and the bases of the upper transistors coupled to that local oscillator input and a block (BRF+, BRF-) adapted to control the bias voltage of a coupling between an input (V_{RF+}, V_{RF-}) configured to receive said signals of a first frequency and the base of the lower transistor coupled to that input.

11. The receiver of any one of the preceding claims 7 to 10, **characterized in that** the adjustment means comprises a digital-to-analog converter (19) to adjust bias voltages and/or currents with a digital controller (12).

12. The receiver of any one of the preceding claims 7 to 11, **characterized in that** it further comprises
- an A/D converter (18) to measure the balance,
- a D/A converter (19) to adjust bias voltages and/or currents, and
- an oscillator (15), a processor (16) and memory (17) to carry out balance measurement routines as well as bias voltage and/or current adjustment routines.

13. A mobile station comprising a receiver according to any of claims 7 to 11.

## Patentansprüche

1. Verfahren zum Vermindern von Störsignalen in einem Mischer eines Empfängers, bei welchem Funksignale von einer ersten Frequenz auf eine zweite Frequenz gemischt werden, wobei das Mischen in einer Gilbert-Zelle erfolgt, die vier obere Transistoren (Q10, Q11, Q13, Q14), welche ein Signal eines lokalen Oszillators an deren Basis empfangen, und zwei untere Transistoren (Q12, Q15), welche Signale einer ersten Frequenz an deren Basis empfangen und mit den vier oberen Transistoren (Q10, Q11, Q13, Q14) gekoppelt sind, aufweist, **dadurch gekennzeichnet, daß** der Mischer durch Einstellen von Bias-Spannungen (3) und/oder Strömen, die an der Basis von ausgewählten der oberen Transistoren anliegen, abgeglichen wird.

2. Verfahren nach Anspruch 1, **dadurch gekennzeichnet, daß** Bias-Spannungen und/oder Ströme in einer Eingangsschaltung eingestellt werden (3), die eine Eingabe eines lokalen Oszillators (V_{LO+}, V_{LO-}) mit der Basis eines oberen Transistors (Q10, Q11, Q13, Q14) verbindet.

3. Verfahren nach Anspruch 1 oder 2, **dadurch gekennzeichnet, daß** Bias-Spannungen und/oder Ströme in einer Eingangsschaltung eingestellt werden (3), welche die Signale einer ersten Frequenz empfängt und diese an die Basis eines unteren Transistors (Q12, Q15) koppelt.

4. Verfahren nach Anspruch 1, 2 oder 3, **dadurch gekennzeichnet, daß** die Bias-Spannungen (3) und/oder Ströme unabhängig für beide Transistoren eines Transistorpaares einer Signalleitung in der Mischerschaltung eingestellt werden.

5. Verfahren nach einem der vorstehenden Ansprüche 1 bis 4, **dadurch gekennzeichnet, daß** die Einstellung der Bias-Spannungen (3) und/oder Ströme mit Hilfe eines Digital-Analog-Wandlers durchgeführt wird, welcher einen Bias-Strom entsprechend eines geladenen Steuerungsbyte erzeugt.

6. Verfahren nach einem der vorstehenden Ansprüche 1 bis 5, **dadurch gekennzeichnet, daß** die Bias-Spannungen (3) und/oder Ströme eingestellt werden, indem ein Abgleich an den Ausgängen des Empfängers, welcher den Mischer umfaßt, gemessen wird (2) und die Bias-Spannungen und/oder Ströme basierend auf den Messungen (4) empirisch eingestellt wird/werden (3).

7. Empfänger mit einem Mischer (10) zum Mischen von Funksignalen von einer ersten Frequenz auf eine zweite Frequenz, umfassend:
- eine Gilbert-Zelle mit vier oberen Transistoren (Q10, Q11, Q13, Q14), deren Basis mit Eingaben eines lokalen Oszillators des Mischers verbunden sind, und zwei unteren Transistoren (Q12, Q15), die angeschlossen sind, um die Signale einer ersten Frequenz an deren Basis zu empfangen, und die mit den vier oberen Transistoren (Q10, Q11, Q13, Q14) gekoppelt sind, und
- ein Mittel zum Vermindern von Störsignalen,
**dadurch gekennzeichnet, daß**
das Mittel zum Vermindern von Störsignalen ein Abgleicheinstellungsmittel (12) aufweist, welches konfiguriert ist, um den Mischerabgleich durch Einstellen von Bias-Spannungen und/oder Strömen einzustellen, die an der Basis von ausgewählten der oberen Transistoren (Q10, Q11, Q13, Q14) anliegen.

8. Empfänger nach Anspruch 7, **dadurch gekennzeichnet, daß** das Einstellungsmittel (12) einen Block (BLO+, BLO-), aufweist, der ausgebildet ist, um die Bias-Spannung einer Kopplung zwischen einer Eingabe eines lokalen Oszillators (V_{LO+}, V_{LO-}) und der Basis der oberen Transistoren, die mit dieser Eingabe eines lokalen Oszillators gekoppelt sind, zu steuern.

9. Empfänger nach Anspruch 7 oder 8, **dadurch gekennzeichnet, daß** das Einstellungsmittel (12) einen Block (BRS+, BRS-) aufweist, welcher ausgebildet ist, um die Bias-Spannung von einer Kopplung zwischen einer Eingabe (V_{RF+}, V_{RF-}), welche die Signale einer ersten Frequenz empfängt, und der Basis des unteren Transistors, der mit dieser Eingabe gekoppelt ist, zu steuern.

10. Empfänger nach Anspruch 7, 8 oder 9, **dadurch gekennzeichnet, daß** das Einstellungsmittel (12) sowohl einen Block (BLO+, BLO-) aufweist, der ausgebildet, um die Bias-Spannung einer Kopplung zwischen einer Eingabe eines lokalen Oszillators (V_{LO+}, V_{LO-}) und der Basis der unteren Transistoren, welche mit dieser Eingabe eines lokalen Oszillators gekoppelt sind, zu steuern, als auch einen Block (BRF+, BRF-) aufweist, der ausgebildet ist, um die Bias-Spannung einer Kopplung zwischen einer Eingabe (V_{RF+}, V_{RF-}), welche die Signale einer ersten Frequenz empfängt, und der Basis des unteren Transistors, welcher mit diesem Signal gekoppelt ist, zu steuern.

11. Empfänger nach einem der vorstehenden Ansprüche 7 bis 10, **dadurch gekennzeichnet, daß** das Einstellungsmittel einen Digital-Analog-Wandler (19) aufweist, um die Bias-Spannungen und/oder Ströme mit einem digitalen Controller (12) zu steuern.

12. Empfänger nach einem der vorstehenden Ansprüche 7 bis 11, **dadurch gekennzeichnet, daß** er weiter aufweist:
- einen A/D-Wandler (18) zum Messen des Abgleiches,
- einen D/A-Wandler (19) zum Einstellen von Bias-Spannungen und/oder Strömen, und
- einen Oszillator (15), einen Prozessor (16) und einen Speicher (17), um Abgleich-Meßroutinen und Routinen zur Einstellung von einer Bias-Spannung und/oder eines Stromes auszuführen.

13. Mobiles Gerät mit einem Empfänger nach einem der Ansprüche 7 bis 11.

## Revendications

1. Procédé en vue d'atténuer des signaux brouilleurs dans un mélangeur d'un récepteur dans lequel des signaux radio d'une première fréquence sont mélangés à une seconde fréquence, dans lequel le mélange est accompli dans une cellule de Gilbert présentant quatre transistors supérieurs (Q10, Q11, Q13, Q14) qui reçoivent un signal d'oscillateur local à leurs bases, et deux transistors inférieurs (Q12, Q15) qui reçoivent lesdits signaux d'une première fréquence à leurs bases et sont couplés auxdits quatre transistors supérieurs (Q10, Q11, Q13, Q14), **caractérisé en ce que** le mélangeur est équilibré en réglant les tensions de polarisation (3) et/ou les courants de polarisation appliqués aux bases des transistors sélectionnés parmi lesdits transistors supérieurs.

2. Procédé selon la revendication 1, **caractérisé en ce que** des tensions de polarisation et/ou des courants de polarisation sont également réglés (3) dans un circuit d'entrée qui connecte une entrée d'oscillateur local (V_{LO+} V_{LO-}) à la base d'un transistor supérieur (Q10, Q11, Q13, Q14).

3. Procédé selon la revendication 1 ou 2, **caractérisé en ce que** des tensions de polarisation et/ou des courants de polarisation sont également réglés (3) dans un circuit d'entrée qui reçoit lesdits signaux d'une première fréquence et couple ces signaux à la base d'un transistor inférieur (Q12, Q15).

4. Procédé selon la revendication 1, 2 ou 3, **caractérisé en ce que** les tensions de polarisation (3) et/ou les courants de polarisation sont réglés séparément pour les deux transistors d'une paire de transistors d'une ligne de transmission de signaux dans le circuit mélangeur.

5. Procédé selon l'une quelconque des revendications précédentes 1 à 4, **caractérisé en ce que** le réglage des tensions de polarisation (3) et/ou des courants de polarisation est exécuté à l'aide d'un convertisseur numérique - analogique qui génère un courant polarisé correspondant à un octet de contrôle transmis avec celui-ci.

6. Procédé selon l'une quelconque des revendications précédentes 1 à 5, **caractérisé en ce que** les tensions de polarisation (3) et/ou les courants de polarisation sont réglés en mesurant (2) un équilibre à partir des sorties d'un récepteur qui comporte ledit mélangeur et en réglant empiriquement les tensions de polarisation (3) et/ou les courants de polarisation sur la base de telles mesures (4).

7. Récepteur comportant un mélangeur (10) en vue de mélanger des signaux radio d'une première fréquence à une seconde fréquence, comportant :
- une cellule de Gilbert présentant quatre transistors supérieurs (Q10, Q11, Q13, Q14) dont les bases sont couplées à des entrées d'oscillateur local du mélangeur, et deux transistors inférieurs (Q12, Q15) couplés en vue de recevoir lesdits signaux d'une première fréquence à leurs bases et couplés auxdits quatre transistors supérieurs (Q 10, Q11, Q 13, Q14), et
- un moyen en vue d'atténuer des signaux brouilleurs, **caractérisé en ce que** le moyen en vue d'atténuer des signaux brouilleurs comporte un moyen de réglage d'équilibre (12) configuré afin de régler l'équilibre du mélangeur en réglant des tensions de polarisation et/ou des courants de polarisation appliqués aux bases de transistors sélectionnés parmi lesdits transistors supérieurs (Q10, Q11, Q 13, Q 14).

8. Récepteur selon la revendication 7, **caractérisé en ce que** le moyen de réglage (12) comporte un bloc (BLO+, BLO-) adapté en vue de commander la tension de polarisation d'un couplage entre une entrée d'oscillateur local (V_{LO+} V_{LO-}) et les bases des transistors supérieurs couplés à cette entrée d'oscillateur local.

9. Récepteur selon la revendication 7 ou 8, **caractérisé en ce que** le moyen de réglage (12) comporte un bloc (BRF+, BRF-) adapté en vue de commander la tension de polarisation d'un couplage entre une entrée (V_{RF+,} V_{RF-}) configurée en vue de recevoir lesdits signaux d'une première fréquence et la base du transistor inférieur couplé à cette entrée.

10. Récepteur selon la revendication 7, 8 ou 9, **caractérisé en ce que** le moyen de réglage (12) comporte à la fois un bloc (BLO+, BLO-) adapté en vue de commander la tension de polarisation d'un couplage entre une entrée d'oscillateur local (V_{LO+} V_{LO-}) et les bases des transistors supérieurs couplés à cette entrée d'oscillateur local et un bloc (BRF+, BRF-) adapté en vue de commander la tension de polarisation d'un couplage entre une entrée (V_{RF+}, V_{RF-}) configurée en vue de recevoir lesdits signaux d'une première fréquence et la base du transistor inférieur couplé à cette entrée.

11. Récepteur selon l'une quelconque des revendications précédentes 7 à 10, **caractérisé en ce que** le moyen de réglage comporte un convertisseur numérique - analogique (19) en vue de régler des tensions de polarisation et/ou des courants de polarisation au moyen d'un contrôleur numérique (12).

12. Récepteur selon l'une quelconque des revendications précédentes 7 à 11, **caractérisé en ce qu'**il comporte en outre
- un convertisseur analogique - numérique (CAN) (18) en vue de mesurer l'équilibre,
- un convertisseur numérique - analogique (CNA) (19) en vue de régler des tensions de polarisation et/ou des courants de polarisation, et
- un oscillateur (15), un processeur (16) et une mémoire (17) en vue d'exécuter des routines de mesure d'équilibre ainsi que des routines de réglage de tensions de polarisation et/ou de courants de polarisation.

13. Station mobile comportant un récepteur selon l'une quelconque des revendications 7 à 11.
